# EUROPEAN PATENT APPLICATION

(11) **EP 4 667 143 A1**
(43) Date of publication of application: **24.12.2025**
(21) Application number: 24756586.4
(22) Date of filing: 24.01.2024
(51) Int. Cl.: B23B 27/14, B23C 5/16, C23C 14/06

(54) **SURFACE-COATED CUTTING TOOL**

(30) Priority: 13.02.2023 JP 2023019953
(71) Applicant: Mitsubishi Materials Corporation, Tokyo 100-8117 (JP)
(72) Inventor: KINOSHITA, Tatsuki, Tokyo 100-8117 (JP)
(74) Representative: Gille Hrabal Partnerschaftsgesellschaft mbB Patentanwälte
(86) International application number: PCT/JP2024/001968
(87) International publication number: WO 2024/171735

(57) **Abstract**

A surface-coated cutting tool having a coating layer in which: a lower layer thereof is a composite nitride layer having an average thickness of 0.1 to 5.0 µm and an average composition of (Al_{1-a-b}TiₐCr_{b})N (0.10 < a ≤ 0.55, 0.05 ≤ b < 0.20, 0.40 ≤ (1-a-b) ≤ 0.70); an upper layer thereof is a composite nitride layer having an average thickness of 0.1 to 5.0 µm and an average composition of (Ti₁₋ₚSiₚ)N (0.10 ≤ p ≤ 0.40); and an intermediate layer thereof has an average thickness of 10 to 500 nm, includes two or more stacked units containing a first layer and a second layer, the first layer being a composite nitride layer having an average thickness of 3 to 17 nm and an average composition of (Ti_{1-ρ}Si_{ρ})N (0.10 ≤ ρ ≤ 0.40, 1.0 ≤ p/ρ ≤ 1.2), and the second layer being a composite nitride layer having an average thickness (Tₘᵤ) of 2 to 12 nm and the same average composition as the lower layer.

## Description

### Technical Field

The present invention relates to surface coated cutting tools (hereinafter also referred to as "coated tools"). This application claims priority based on Japanese Patent Application No. 2023-019953 filed on February 13, 2023. The entire description in the Japanese patent application is hereby incorporated by reference.

### Background Art

Coated tools are known that include coating layers formed on the surfaces of substrates composed of, for example, tungsten carbide (hereinafter referred to as WC) based cemented carbide, in order to improve the life of the cutting tools. These coated tools have improved wear resistance.

In addition, various proposals have been made regarding the composition and structure of the coating layer to further improve the cutting performance of the coated tool.

PTL 1 discloses a coated tool that includes alternating layers of one or more A layers and one or more B layers alternately laminated. The A layers each comprises a nitride containing Al and Cr, where the relative number of Cr atoms is greater than 0 and less than 0.4 with the proviso that the total number of metal atoms constituting the A layer is 1. The B layers each comprises a nitride containing Ti and Si without Al, where the relative number of Si atoms is greater than 0.05 and less than 0.3 with the proviso that the total number of metal atoms constituting said B layer is 1. The coating segment has high oxidation resistance and adhesion resistance even under high temperatures during cutting and thus the cutting edge of the coated tool exhibits reduced chipping.

PTL 2 discloses a coated tool that includes a coating segment including two or more I layers and II layers alternately laminated. The I layers each comprises nitride or carbide of AlₐTi_{b}Cr_{c} where 0.3 ≤ a ≤ 0.7, 0 ≤ b ≤ 0.5, 0 ≤ c ≤ 0.7, and a+b+c = 1) and the II layers each comprises a composite nitride layer comprising CrAlN phases and BN phases distributed in a three-dimensional manner. The bottommost I layer is disposed on a substrate while the topmost II layer serves as the topmost surface. The I layers and II layers each have an average thickness over 50 nm, and the total average thickness of the coating segment is 0.1 to 20 µm. The coating segment has high heat resistance, high chemical stability at high temperatures, high wear resistance, and high welding resistance.

PTL 3 discloses a coated tool that includes a substrate and a coating layer. The coating layer includes an A sublayer formed on the substrate and a B sublayer formed directly above the A sublayer. The A sublayer is a Si-free coating film of TiAlCr nitride, oxynitride, carbonitride or oxycarbonitride, and consists of fine columnar cubic crystals, where each columnar crystal has a width of less than 300 nm in a direction orthogonal to the direction of the growth of the columnar crystals. The B sublayer is a Si-containing coating film mainly composed of SiTi nitride. The coated tool has high wear resistance and durability.

PTL 4 discloses a coated tool that includes a coating layer. The coating layer includes a first sublayer consisting of alternatingly laminated first films made of Si-containing nitride and second films made of AlCr-containing nitride, and a second sublayer made of Si-containing nitride on the surface of the first sublayer, the second sublayer being thicker than the first and second films. The coated tool has high hardness due to the micronized crystals of the coating segment.

PTL 5 discloses a coated tool that includes a coating layer including a substrate, an adhesive layer on a substrate and a top layer on the adhesive layer. The top layer is composed of TiAlN, TiAlSiN or TiSiN. The adhesive layer has a thickness of 2 nm to 20 nm or less and contains Cr, Ti, Al, W, C and N (but not containing Co). The coated tool has high durability.

PTL 6 discloses a coated tool that includes a coating layer including a bottom coating segment, a top coating segment, and an intermediate coating segment formed between them. The intermediate coating segment includes one or more first sublayers comprising nitrides or carbonitrides of Al, Cr and Ti and one or more second sublayers comprising nitrides or carbonitrides of Ti and Si, alternatingly laminated. The metal components of the first sublayer have a composition represented by AlₓCr_{y}Ti_{z} where x+y+z = 100, 50 ≤ x ≤ 65, 20 ≤ y ≤ 30, and 5 ≤ z ≤20, while the metal components of the second sublayer have a composition represented by TiₐSi_{b} where a+b = 100, 80 ≤ a ≤ 90, and 10 ≤ b ≤ 20. The coating segment haves high crack resistance and high delamination resistance.

PTL 7 discloses a coated tool that includes a coating layer. The coating layer includes first sublayers consisting of TiₘSi₁₋ₘN_{1-a-b}CₐB_{b} and second sublayers consisting of AlₓCr_{y}M_{1-x-y}N_{1-a-b}CₐB_{b} alternatingly laminated, wherein in the first sublayer 0.7 ≤ m < 1 and 0 < 1-a-b ≤ 1, and in the second sublayer 0.7 < x ≤ 0.8, 0 < y and 0 < 1-a-b ≤ 1. M is at least one element selected from the group consisting of Ti, V, Zr, Nb, Mo, Ta, W, Y and lanthanoid (excluding Pm). The coated tool has high wear resistance.

### Citation List

### Patent Literature

PTL 1: Japanese Patent No. 5254552
PTL 2: Japanese Unexamined Patent Publication No. 2013-52477
PTL 3: Japanese Patent No. 4960751
PTL 4: Japanese Unexamined Patent Publication No. 2021-70075
PTL 5: Japanese Patent No. 6773287
PTL 6: Japanese Unexamined Patent Publication No. 2020-20030
PTL 7: Japanese Unexamined Patent Publication No. 2017-179580

### Summary of Invention

### Technical Problem

An object of the present invention, which has been accomplished in view of the aforementioned circumstances and proposals, is to provide a coated tool having high durability even in high-speed cutting of difficult-to-cut materials, such as Ni-based alloys.

### Solution to Problem

A surface coated cutting tool of an embodiment of the present invention comprises a substrate and a coating segment on the substrate,
the coating segment comprising a bottom layer, an intermediate layer, and a top layer in order from the surface of the substrate to the surface of the tool, the bottom and top layers having an average total thickness of 1.0 to 8.0 µm,
the bottom layer comprising a composite nitride layer having an average thickness (Tₗ) of 0.1 to 5.0 µm and an average composition represented by (Al_{1-a-b}TiₐCr_{b})N where 0.10 <a ≤ 0.55, 0.05 ≤ b < 0.20, and 0.40 ≤ (1-a-b) ≤ 0.70),
the top layer comprising a composite nitride layer having an average thickness (Tᵤ) of 0.1 to 5.0 µm and an average composition represented by (Ti₁₋ₚSiₚ)N where 0.10 ≤ p ≤ 0.40,
the intermediate layer having an average thickness (Tₘ) of 10 to 500 nm and comprising two or more lamination units each including a first lower sublayer adjacent to the bottom layer and a second upper sublayer adjacent to the top layer,
   the first lower sublayer comprising a composite nitride layer having an average thickness (Tₘₗ) of 3 to 17 nm and an average composition represented by (Ti_{1-ρ}Si_{ρ})N where 0.10 ≤ ρ ≤ 0.40 and 1.0 ≤ p/ρ ≤ 1.2,
   the second upper sublayer comprising a composite nitride layer having an average thickness (Tₘᵤ) of 2 to 12 nm and the same average composition as the bottom layer.

The surface coated cutting tool according to the embodiment may satisfy the following item (1):
(1) The average thickness (Tₗ) of the bottom layer and the average thickness (Tᵤ) of the top layer hold the following relation: 0.2 ≤ Tᵤ/Tₗ ≤ 9.0.

### [Advantageous Effects of Invention]

As described above, the surface-coated cutting tools have high durability even in high-speed cutting of difficult-to-cut materials, such as Ni-based alloys.

### Brief Description of Drawing

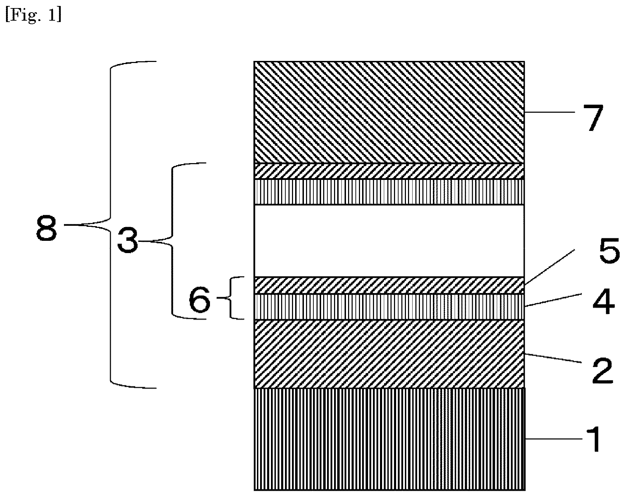

Figure 1 is a schematic longitudinal cross-sectional view of the coating segment of one embodiment of the invention.

### Description of Embodiments

The inventor has focused on a coating segment including a laminate of nitride layers containing Al, Ti, and Cr and nitride layers containing Ti and Si, both of which layers have high durability, and has made a series of intensive examinations. As a result, the inventor found that the aforementioned objectives could be achieved by a coating segment having a middle portion with a multilayer structure that has an optimized composition and a thickness within a specified range.

A coated tool of the embodiment of the present invention based on this finding will now be described in detail.

Throughout the specification and the claims, the numerical range expressed as "L to M" (L and M are both numerical values) includes the upper limit (M) and the lower limit (L). When a unit is stated only for the upper limit, the upper (M) and lower (L) limits have the same unit. In addition, each value includes an experimental error.

The surface of the substrate referred to in the specification and the claims corresponds to the average line (straight line) arithmetically determined from a roughness curve of the interface between a layer, closest to the surface of the substrate, of the coating segment and the substrate. This method of determining the average line enables even the interface between the coating segment and the substrate to be regarded as flat because the diameter of the tool, i.e., the diameter of the substrate is large enough relative to the thickness of the coating segment even if the substrate has a curved surface.

Figure 1 illustrates a schematic diagram of a longitudinal section perpendicular to the surface of a coated tool where the substrate is regarded as a plane, regardless of minute irregularities on the surface of the substrate.

As is clear from Figure 1, a coating segment (8) has a bottom layer (2) directly above a substrate (1), an intermediate layer (3) directly above the bottom layer, and a top layer (7) directly above the intermediate layer. The intermediate layer has two or more lamination units (6) including a first lower sublayer (4) adjacent to the bottom layer and a second upper sublayer (5) adjacent to the top layer. The lamination units including the first lower sublayer and the second upper sublayer are also present in the white area in the region indicated as the intermediate layer.

These layers will now be described in sequence.

### 1. Bottom layer

The bottom layer is provided directly above the substrate. The bottom layer should preferably have an average thickness (Tₗ) in the range of 0.1 to 5.0 µm for the following reason: A thickness of less than 0.1 µm leads to insufficient wear and chipping resistances of the bottom layer, while a thickness exceeding 5.0 µm leads to an increase in the internal strain of the bottom layer, resulting in ready self-destruction of the bottom layer. The average thickness is more preferably 0.2 to 4.0 µm, even more preferably 0.3 to 3.6.

The bottom layer should preferably comprise a composite nitride layer with an average composition represented by (Al_{1-a-b}TiₐCr_{b})N where 0.10 < a ≤ 0.55, 0.05 ≤ b < 0.20, and 0.40 ≤ (1-a-b) ≤ 0.70. The reasons why it is preferable for subscripts a indicating the Ti content and b indicating the Cr content to satisfy the aforementioned ranges, respectively, are as follows:

Only a combination of subscript a greater than 0.10 and subscript b greater than 0.05 can achieve an improvement in toughness caused by composite nitride with a different lattice constant provided directly above the bottom layer. Subscript a exceeding 0.55 leads to decreased durability of the coated tool due to a decrease in the Al content, whereas subscript b of 0.20 or more leads to softening of the bottom layer and thus a reduction in wear resistance. Furthermore, subscript (1-a-b) of less than 0.40 leads to reductions in the high-temperature hardness and high-temperature oxidation resistance of the bottom layer. On the contrary, subscript exceeding 0.70 leads to unfavorable formation of crystal grains with a hexagonal crystal structure, resulting in a reduction in the hardness of the bottom layer and thus insufficient wear resistance. More preferably, subscript a is within a range of 0.15 to 0.55, subscript b 0.05 to 0.15, and subscript (1-a-b) 0.50 to 0.65. Even more preferably, subscript a is within a range of 0.20-0.37, subscript b 0.08-0.15, and subscript (1-a-b) 0.55-0.65.

In one exemplary method described below, the ratio of (Al_{1-a-b}TiₐCr_{b}) to N is 1:1. However, there may be some that are unintentionally not 1:1. This is also true for the other composite nitrides discussed below.

### 2. Top layer

The top layer is provided directly above the intermediate layer described below and functions as the surface of the coating segment. The top layer should preferably have an average thickness (Tᵤ) of 0.1 to 5.0 µm for the following reason: An average thickness of less than 0.1 µm leads to a reduction in the wear resistance of the top layer, while a thickness exceeding 5.0 µm facilitates occurrence of chipping and loss of the top layer. The average thickness is more preferably 0.2 to 4.0 µm, even more preferably 0.3 to 3.6 µm.

The sum of the average thickness of the top layer (Tᵤ) and the average thickness of the bottom layer (Tₗ) should preferably range from 1.0 to 8.0 µm for the following reason: A thickness of less than 1.0 µm causes the coating segment not to demonstrate high wear resistance over a long period of use, while a thickness exceeding 8.0 µm causes the top layer to be prone to abnormal damage, such as chipping, fracturing, and delamination. The sum of the average thickness of the top layer and the bottom layer is more preferably 1.0 to 5.0 µm.

The ratio of the average thickness (Tᵤ) of the top layer to the average thickness (Tₗ) of the bottom layer should more preferably satisfy the relation: 0.2 ≤ Tᵤ/Tₗ ≤ 9.0 for the following reasons: A ratio of less than 0.2 often causes the wear resistance and oxidation resistance in the top layer to be insufficient and the adhesion strength between the substrate and the bottom layer to be insufficient. A ratio exceeding 9.0 may cause excess residual stress of the entire coating, resulting in self-destruction and delamination. The ratio Tᵤ/Tₗ should more preferably satisfy the relation: 0.2 ≤ Tᵤ/Tₗ ≤ 4.0.

The top layer should preferably comprise a composite nitride layer with an average composition represented by (Ti₁₋ₚSiₚ)N where 0.10 ≤ p ≤ 0.40 for the following reasons: Subscript p of less than 0.10 precludes the oxidation resistance and lubricating property by addition of Si. Subscript p exceeding 0.40 causes significantly large residual stress, resulting in chipping in the top layer. Subscript p is more preferable in the range of 0.10 to 0.30, even more preferable in the range of 0.15 to 0.25.

### 3. Intermediate layer

The intermediate layer is provided directly above the bottom layer and directly below the top layer. The intermediate layer includes two or more lamination units consisting of first lower sublayers adjacent to the bottom layer and second upper sublayers adjacent to the top layer.

The first lower sublayer adjacent to the bottom layer should preferably comprise a composite nitride layer with an average composition represented by (Ti_{1-ρ}Si_{ρ})N where 0.10 ≤ ρ ≤ 0.40 and 1.0 ≤ p/ρ ≤ 1.2 for the following reasons: A ratio p/ρ satisfying this range leads to a reduction in lattice distortion in the intermediate layer and an improvement in adhesion with the adjacent upper lamination unit layer. A ratio p/ρ less than 1.0 or more than 1.2 causes a large difference in composition from the top layer, i.e., a steep change in Si content, resulting in a reduction in the chipping resistance of the intermediate layer.

The second upper sublayer adjacent to the top layer should preferably comprise a composite nitride layer with an average composition that is represented by (Al_{1-a-b}TiₐCr_{b})N where 0.05 ≤ a, 0.05 ≤ b <0.20, and 0.40 ≤ (1-a-b) ≤ 0.70 and that is the same as the average composition of the bottom layer (subscripts a and b having the same values) for the following reasons: The same average composition between the second upper sublayer and the bottom layer prevents residual stress from being concentrated in the intermediate layer and improves adhesion between the bottom and top layers.

Preferably, the first lower sublayer adjacent to the bottom layer should have an average thickness (Tₘₗ) of 3 to 17 nm and the second upper sublayer adjacent to the top layer should have an average thickness (Tₘᵤ) of 2 to 12 nm for the following reasons: In the case that these ranges are satisfied, the crystal grains constituting the lamination unit layer adjacent to the top layer and the lamination unit layer adjacent to the bottom layer is fine, the grain boundary area increases, and thus plastic deformation and crack propagation are suppressed at the grain boundaries.

The sum of the average thickness (Tₘₗ) of the first lower sublayer adjacent to the bottom layer and the average thickness (Tₘᵤ) of the second upper sublayer adjacent to the top layer more preferably ranges from 5 to 20 nm. Within this range, the aforementioned objective is more reliably achieved.

The intermediate layer should preferably have an average thickness of 10 to 500 nm. Although the reason for this is not known, it is speculated that a thickness of less than 10 nm leads to an insufficient improvement in the adhesion between the bottom and top layers, while a thickness exceeding 500 nm facilitates cracking in the intermediate layer due to the large residual stress of the lamination unit layer adjacent to the bottom layer, which in turn causes a decrease in adhesion. The average thickness is more preferably ranges from 10 to 450 nm, even more preferably from 10 to 250 nm, most preferably from 20 to 150 nm.

To achieve the average thickness of the intermediate layer to the aforementioned desirable range, it is preferred that 2 to 100 layers are laminated. Within the number of layers in this range, cracks are less likely to occur in the coating segment, and chipping resistance is improved. A laminating number of 5 to 50 is more preferred, and 6 to 20 is even more preferred.

### 4. Other layers

### (5-1) Optional layer

Although the combination alone of the bottom, intermediate, and top layers is sufficient to satisfy the object of the present invention, an optional surface layer may be provided in addition to these layers.

### Surface layer

A typical surface layer may be composed of TiN, which has a golden color tone that varies with the state of use of the coated tool and can thus be used, for example, as an identification layer to determine the state of the use of the coated tool. The TiN identification layer may have an average thickness of, for example, 0.1 to 1.0 µm.

### (5-2) Layers that may occur incidentally

In the embodiment, the bottom, intermediate, top, and surface layers are deposited such that no other layers are formed. However, a change in pressure or a fluctuation in temperature in the deposition system may occur unintentionally during switching of the type of layers to be deposited. In such a case, a layer with a different composition from these layers may be unintentionally or incidentally formed between these layers. This layer is referred to as a layer that may occur incidentally.

### 2. Substrate

### (1) Material

The substrate in this embodiment may comprise any known material that can achieve aforementioned object. Examples of such material include cemented carbides (WC-based cemented carbides, including those containing Co in addition to WC, and also including those to which carbides such as Ti, Ta, and Nb are added), Cermets (for example, those mainly composed of TiC, TiN, and TiCN), ceramics (for example, titanium carbide, silicon carbide, silicon nitride, aluminum nitride, aluminum oxide), cBN sinters, and diamond sinters.

### (2) Shape

The substrate may have any shape that can be used as a cutting tool. Examples of the cutting tool include inserts, end mills, drills, and other tools.

### 3. Measurement of average composition

A longitudinal section (a cross-section perpendicular to the surface without microscopic irregularities of the substrate is cut out with a focused ion beam (FIB) system. The thicknesses of all the layers in the cross section are measured at five different locations for each layer with a scanning electron microscope (SEM). The thickness is determined at any magnification suitable for the measurements. For example, the thicknesses of the bottom layer, the top layer, and the entire coating segment are observed at a magnification of 5,000 to 200,000, and the thicknesses of the intermediate layer, the lamination unit layer adjacent to the top layer, and the lamination unit layer adjacent to the bottom layer is observed at a magnification of 100,000 to 500,000. The thickness of each layer is averaged from the values at five locations for that layer. In the case that only one layer is present in the cross section, the results of five locations for this layer are averaged. In addition, the compositions of the bottom, intermediate, and top layers are measured at five locations for each layer in the cross-section using energy dispersive X-ray analysis (EDS) attached to the SEM, and the average composition is calculated from the average values.

### 4. Production

The coating segment of the embodiment can be produced, for example, by the following PVD process. An arc ion plating (AIP) system is purged with a nitrogen atmosphere, and an arc discharge is generated between an Al-Ti-Cr alloy target of a predetermined composition and an anode to form a bottom layer with a predetermined average thickness. Another arc discharge is then generated between the Ti-Si alloy target of a predetermined composition and the anode also in a nitrogen atmosphere to form a first lower sublayer with a predetermined average thickness adjacent to the bottom layer, and an arc discharge is generated between the Al-Ti-Cr alloy target and the anode to form a second upper sublayer with a predetermined average thickness adjacent to the top layer. A lamination unit is thereby formed. After two or more lamination units are deposited, an arc discharge is generated between a Ti-Si alloy target of another predetermined composition and an anode in a nitrogen atmosphere to deposit a top layer with a predetermined average thickness.

The above description is summarized by the features that are appended below.

### (Appendix 1)

A surface coated cutting tool comprising a substrate and a coating segment on the substrate,
the coating segment comprising a bottom layer, an intermediate layer, and a top layer in order from the surface of the substrate to the surface of the tool, the bottom and top layers having an average total thickness of 1.0 to 8.0 µm,
the bottom layer comprising a composite nitride layer having an average thickness (Tₗ) of 0.1 to 5.0 µm and an average composition represented by (Al_{1-a-b}TiₐCr_{b})N where 0.10 <a ≤ 0.55, 0.05 ≤ b < 0.20, and 0.40 ≤ (1-a-b) ≤ 0.70),
the top layer comprising a composite nitride layer having an average thickness (Tᵤ) of 0.1 to 5.0 µm and an average composition represented by (Ti₁₋ₚSiₚ)N where 0.10 ≤ p ≤ 0.40,
the intermediate layer having an average thickness (Tₘ) of 10 to 500 nm and comprising two or more lamination units each including a first lower sublayer adjacent to the bottom layer and a second upper sublayer adjacent to the top layer,
   the first lower sublayer comprising a composite nitride layer having an average thickness (Tₘₗ) of 3 to 17 nm and an average composition represented by (Ti_{1-ρ}Si_{ρ})N where 0.10 ≤ ρ ≤ 0.40 and 1.0 ≤ p/ρ ≤ 1.2,
   the second upper sublayer comprising a composite nitride layer having an average thickness (Tₘᵤ) of 2 to 12 nm and the same average composition as the bottom layer.

### (Appendix 2)

The surface coated cutting tool described in Appendix 1, wherein the average thickness (Tₗ) of the bottom layer and the average thickness (Tᵤ) of the top layer hold the following relation: 0.2 ≤ Tᵤ/Tₗ ≤ 9.0.

### (Appendix 3)

The surface coated cutting tools described in Appendix 1 or 2, wherein the lamination units includes 2 and 100 lamination units.

### (Appendix 4)

The surface coated cutting tool described in any of Appendices 1 to 3, wherein the sum of the average thickness of the first lower sublayer (Tmₗ) and the average thickness of the second upper sublayer (Tₘᵤ) is 2 to 12 nm.

### Examples

The embodiment of the present invention will now be described in detail by way of nonlimiting examples.

WC powder, TiC powder, VC powder, TaC powder, NbC powder, Cr₃C₂ powder, and Co powder were prepared as raw material powders. These raw powders were compounded into compositions shown in Table 1, and then wax was added. Each mixture was wet-blended in a ball mill for 72 hours, dried under reduced pressure, pressed under a pressure of 100 MPa to form compacts that were then sintered to form round bar sintered compacts with a diameter of 6 mm for formation of substrates. Each sintered compact was subjected to grinding work into end mill substrates 1 to 4 made of WC-based cemented carbide, each substrate having a groove portion with a diameter of 6 mm and a length of 60 mm and a two-flute cutting-edge with a 45-degree torsional angle.

End mill substrates 1 to 4 were then ultrasonically cleaned in acetone and were dried.

The end mill substrates were mounted in the circumferential direction at a predetermined distance from the center axis on a turn table of an AIP system. A target (cathode) made of an Al-Ti-Cr alloy of a predetermined composition was placed on one side of the AIP system and two targets (cathodes) made of Ti-Si alloys of different predetermined compositions were placed on the other side.

While the inside of the AIP system was evacuated to maintain a vacuum pressure (1×10⁻³ Pa or lower), the system was heated to 500°C with a heater. A DC bias voltage of -400 V was then applied to the end mill substrates spinning on the rotary table, and the substrates were subjected to Ar ion bombardment for 15 minutes with an ion source generated by emission of thermal electrons from the filament.

Coating layers were formed on end mill substrates 1 to 4 by the following process to produce surface coated end mills 1 to 18 (hereinafter referred to as Examples 1 to 18), respectively.

### Production of Coating Layer

Example coating layers shown in Table 3 were produced through Procedures 1) to 5) as follows:

### 1) Deposition of Bottom Layer

While nitrogen reaction gas was introduced into the system to maintain the nitrogen pressure as shown in Table 2 as the deposition conditions of the lower layer, the temperature of the end mill substrates spinning on the turn table was maintained at a temperature shown in Table 2. A DC bias voltage as shown in Table 2 was applied to the end mill substrates, a current of 150 A was applied between the Al-Ti-Cr alloy target and the anode to generate an arc discharge to deposit a bottom layer with a composition and average thickness as shown in Table 3 on the surface of each end mill substrate.

### 2) Deposition of First Lower Sublayer adjacent to bottom layer

The nitrogen pressure was maintained at the deposition condition for the first lower sublayers as shown in Table 2. While the temperature of the end mill substrate spinning on the turn table was maintained at a temperature shown in Table 2, the DC bias voltage shown in Table 2 was applied to the end mill substrates and a current of 100 A was applied between the Ti-Si alloy target and the anode to generate an arc discharge. The first lower sublayer, adjacent to the bottom layer, with the composition and average thicknesses shown in Table 3 was thereby deposited on the surface of the end mill substrate.

### 3) Deposition of Second Upper Sublayer adjacent to the top layer

The nitrogen pressure was maintained at the deposition condition for the second upper sublayers as shown in Table 2. While the temperature of the end mill substrate spinning on the turn table was maintained at the temperature shown in Table 2, a DC bias voltage shown in Table 2 was applied to the end mill substrates and a current of 150 A was applied between the Al-Ti-Cr alloy target and the anode to generate an arc discharge. The second upper sublayer with the composition and average thicknesses shown in Table 3 was thereby deposited on the surface of the first lower substrate, adjacent to the top layer.

### 4) Production of Intermediate Layer

Procedures 2) and 3) were repeated to form an intermediate layer including a predetermined number of lamination units.

### 5) Deposition of Top Layer

The system was maintained at a nitrogen pressure indicated in the deposition condition for the top layer shown in Table 2 and the end mill substrate spinning on the turn table was maintained at a temperature shown in Table 2. While a DC bias voltage shown in Table 2 was applied to the end mill substrates, and a current of 100 A was applied between a Ti-Si alloy target of a specified composition and the anode to generate an arc discharge. A top layer with a composition and average thickness shown in Table 3 was thereby deposited above the surface of the end mill substrate.

For comparison, end mill substrates 1 to 4 were ultrasonically cleaned in acetone, were dried, and were mounted in the circumferential direction at a predetermined distance from the center axis on the turn table in the AIP system, and bombarded in the same manner as in Examples 1 to 18 under the deposition conditions 1' to 19' shown in Table 2 to produce surface coated end mills 1' to 19' (hereinafter referred to as Comparative examples 1' to 19'), respectively.

The average thickness and composition were determined for Examples 1-18 and Comparative Examples 1' to 19' produced as described above by the aforementioned procedures. The number of layers was calculated from the ratio of the thickness of the intermediate layer to the thickness of the lamination unit layer.

Table 3 shows the results of the observed and calculated data.

**[Table 1]**

| Substrate | Composition | | | | | | |
|---|---|---|---|---|---|---|---|
| | Co | Ti C | VC | TaC | NbC | Cr₃C₂ | WC |
| 1 | 5. 9 | - | 0.3 | 3.1 | - | - | Balance |
| 2 | 8. 2 | - | 2.0 | - | - | 0.3 | Balance |
| 3 | 9. 7 | - | 1.2 | - | 0.5 | 0.7 | Balance |
| 4 | 12.0 | 2. 5 | - | - | 2. 2 | - | Balance |

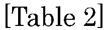

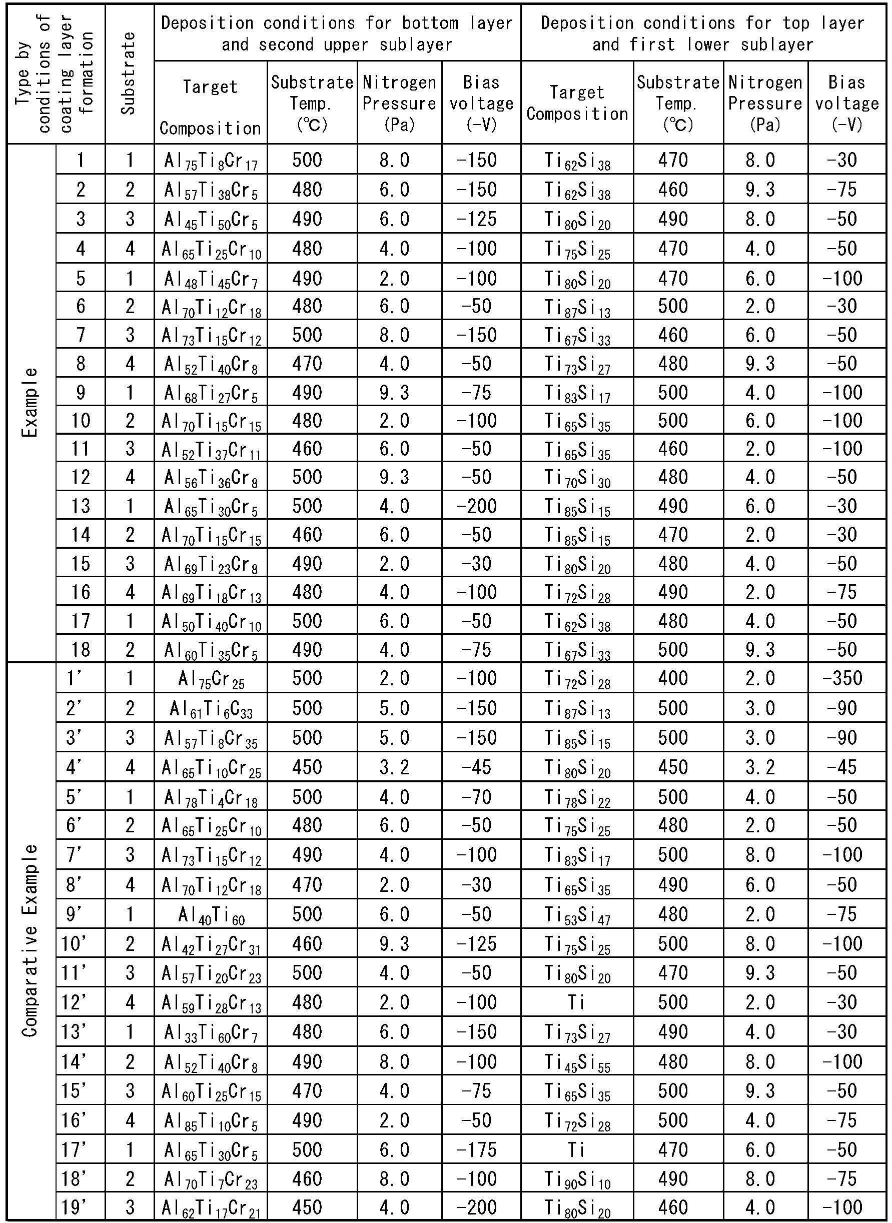

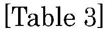

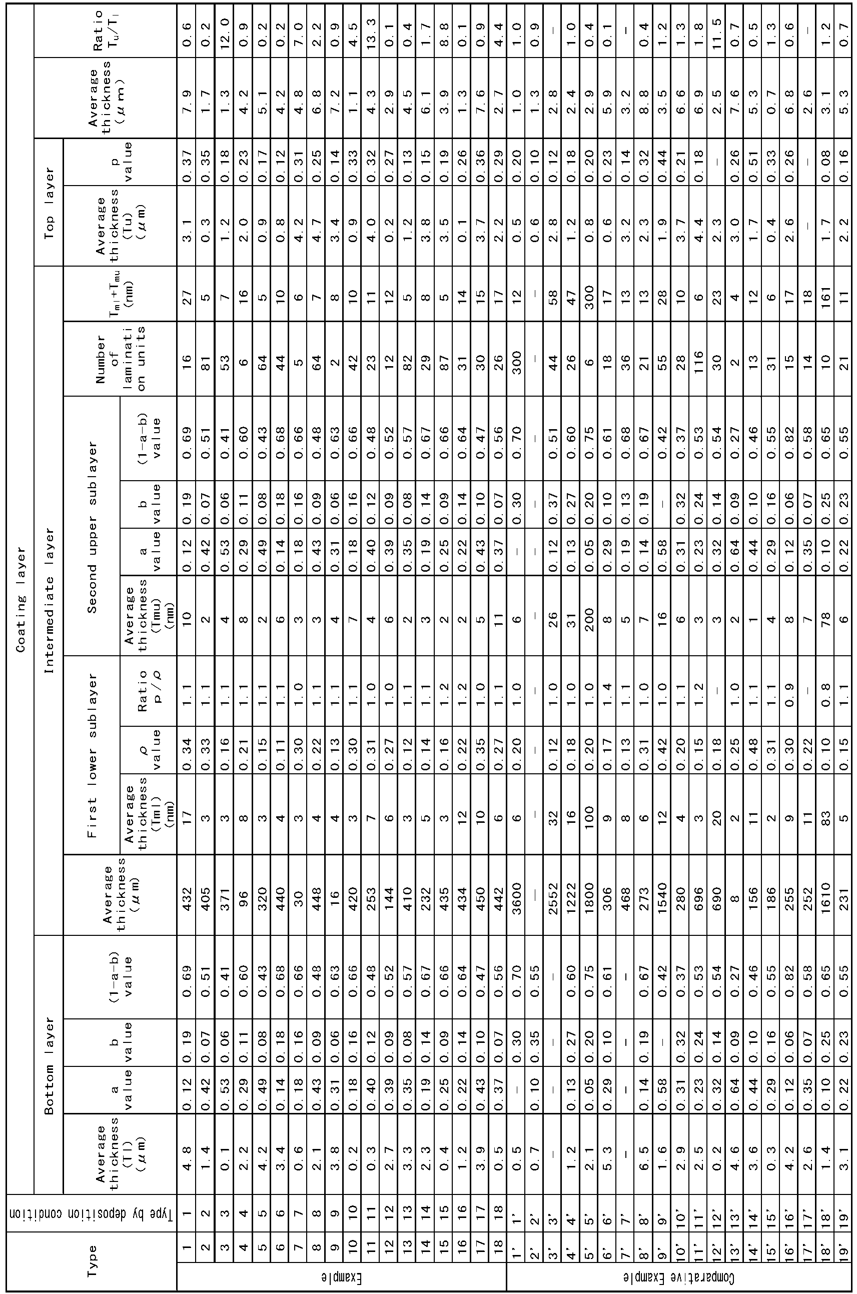

In Tables 1 and 3, the symbol "-" indicates no applicable items.

Examples 1 to 18 and Comparative Examples 1' to 19' were subjected to a cutting test under the following cutting conditions, to measure the flank wear width. The results are shown in Table 4.

### <Cutting Conditions>

Material to be cut: plate of Ni-based heat-resistant alloy (18 mass% Cr - 18 mass% Fe - 5 mass% Nb - 3 mass% Mo - 1 mass% Ti - 0.5 mass % Al -Ni balance) with a flat surface of 75 mm by 150 mm and a thickness of 250 mm.
Cutting speed: 100 m/min.
Feeding rate: 0.05 mm/tooth
Cutting depth: ap 2.4 mm, ae 0.3 mm
Cutting length: 50 m
Cutting fluid: water-soluble coolant

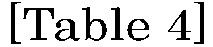

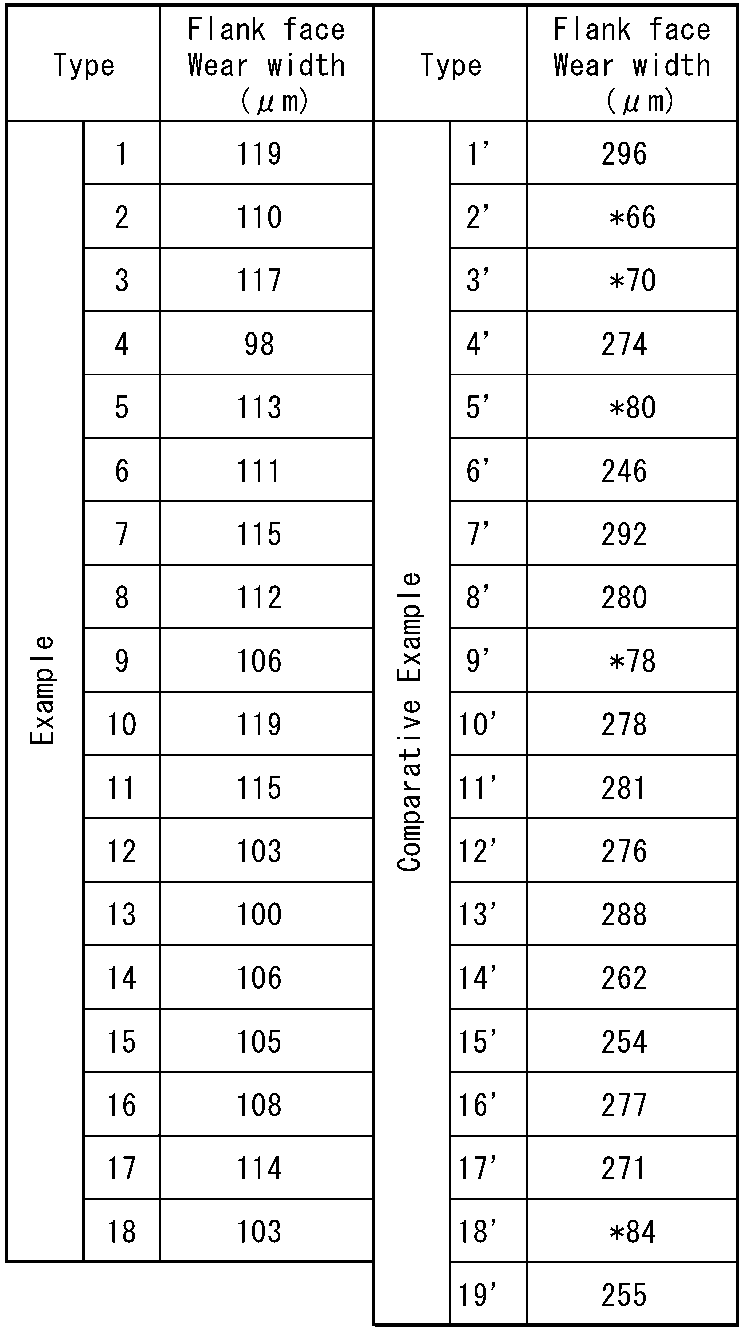

In Table 4, symbol "*" indicates the time until the sample reaches the service life from the exposed substrate before a cutting length of 50 m by detecting the abnormal noise generated by damage to the coating layer, which is presumed to be caused by delamination, welding, chipping, or wear every minute.

Table 4 evidentially demonstrates that all Examples 1 to 18 have a small clearance surface wear width and are durable, whereas all Comparative examples 1' to 19' have a large clearance surface wear width and reach the ends of their service live before the cutting length of the cutting test.

The disclosed embodiments are in all respects illustrative only and are not restrictive. The scope of the invention is indicated by the claims, not the embodiments, and is intended to include all modifications within the gist and scope of the claims and equivalents.

### [Reference Numerals]

1 Substrate
2 Bottom layer
3 Intermediate layer
4 First lower layer adjacent to bottom layer
5 Second upper layer adjacent to top layer
6 Lamination unit
7 Top layer
8 Coating segment

## Claims

1. A surface coated cutting tool comprising a substrate and a coating segment on the substrate,
the coating segment comprising a bottom layer, an intermediate layer, and a top layer in order from the surface of the substrate to the surface of the tool, the bottom and top layers having an average total thickness of 1.0 to 8.0 µm,
the bottom layer comprising a composite nitride layer having an average thickness (Tₗ) of 0.1 to 5.0 µm and an average composition represented by (Al_{1-a-b}TiₐCr_{b})N where 0.10 <a ≤ 0.55, 0.05 ≤ b < 0.20, and 0.40 ≤ (1-a-b) ≤ 0.70),
the top layer comprising a composite nitride layer having an average thickness (Tᵤ) of 0.1 to 5.0 µm and an average composition represented by (Ti₁₋ₚSiₚ)N where 0.10 ≤ p ≤ 0.40,
the intermediate layer having an average thickness (Tₘ) of 10 to 500 nm and comprising two or more lamination units each including a first lower sublayer adjacent to the bottom layer and a second upper sublayer adjacent to the top layer,
the first lower sublayer comprising a composite nitride layer having an average thickness (Tₘₗ) of 3 to 17 nm and an average composition represented by (Ti_{1-ρ}Si_{ρ})N where 0.10 ≤ ρ ≤ 0.40 and 1.0 ≤ p/ρ ≤ 1.2,
the second upper sublayer comprising a composite nitride layer having an average thickness (Tₘᵤ) of 2 to 12 nm and the same average composition as the bottom layer.

2. The surface coated cutting tool as claimed in claim 1, wherein the average thickness (Tₗ) of the bottom layer and the average thickness (Tᵤ) of the top layer hold the following relation: 0.2 ≤ Tᵤ/Tl ≤ 9.0.
